# EUROPÄISCHE PATENTSCHRIFT

(11) **EP 0 806 720 B1**
(45) Veröffentlichungstag und Bekanntmachung des Hinweises auf die Patenterteilung: **29.08.2001**
(21) Anmeldenummer: 97107739.1
(22) Anmeldetag: 12.05.1997
(51) Int. Cl.: G06F 1/18, H05K 7/14

(54) **Halterung für einen Schaltkreis an einem Baugruppenträger**
Support for a circuit in equipment
Dispositif pour supporter un circuit dans un équipement

(30) Priorität: 10.05.1996 DE 19618994
(43) Veröffentlichungstag der Anmeldung: 12.11.1997
(73) Patentinhaber: Wincor Nixdorf GmbH & Co KG, 33106 Paderborn (DE)
(72) Erfinder: Kamin, Hartmut, 10585 Berlin (DE)

(56) Entgegenhaltungen:
- US-A- 4 744 006
- US-A- 5 004 867
- US-A- 5 251 109

## Beschreibung

Die Erfindung betrifft eine Halterung für wenigstens einen elektronischen Schaltkreis, die diesen gegen Manipulation und unbefugte Entfernung von einem Baugruppenträger sichert. Eine Halterung dieser Art ist bereits aus Dokument US 5 251 109 bekannt.

Es sind Computeranwendungen bekannt, bei denen ein datenverarbeitendes Gerät, also die sogenannte Hardware, zertifiziert oder ein lizenzpflichtiges Computerprogramm nur für ein bestimmtes Gerät freigegeben wird. Beispielsweise sind in verschiedenen Ländern für Registrierkassen sogenannte Fiskalspeicher gesetzlich vorgeschrieben, in denen unlöschbar und unveränderbar eine Steuerbezeichnung, eine Matrikelnummer, die laufenden Nummern der ausgegebenen Kassenbons und die darauf abgedruckten Umsatzdaten gespeichert werden. Solche Speicherelemente müssen unlösbar am Gehäuse des Gerätes befestigt sein. Ähnliches gilt für kodierte Schaltkreise, sogenannte "Dongles", die vorhanden sein müssen, damit ein mit dem Dongle geschütztes Computerprogramm ablaufen kann.

Bisher hatten Geräte der genannten Art einen hersteller- und anwendungsspezifischen Aufbau, bei dem eine mechanische Sicherung der genannten elektronischen Schaltkreise durch individuelle konstruktive Maßnahmen erfolgte. Heute werden diese Geräte zunehmend aus marktgängigen Komponenten, beispielsweise aus dem PC-Umfeld aufgebaut. Der Aufbau dieser Komponenten -sowohl der elektronischen Einschubbaugruppen wie auch der Baugruppenträger- ist weitgehend standardisiert, und auch für besondere Anwendungsfälle benötigte spezielle elektronische Einschubbaugruppen sollen diesen Standards genügen.

Aufgabe der Erfindung ist es daher, eine Halterung für elektronische Schaltkreise vorzuschlagen, die diese sowohl gegen unbefugte Entfernung von einem Baugruppenträger als auch gegen nicht bemerkbare Manipulationen an dem Schaltkreis sichert.

Die Aufgabe wird durch die kennzeichnenden Merkmale des Anspruchs 1 gelöst.

Die Erfindung geht von der Feststellung aus, daß bei solchen elektronischen Geräten, die einem Standard der sogenannten offenen Computerwelt genügen, die einzelnen elektronischen Baugruppen als leicht auszutauschende Steckbaugruppen mit einer Frontblende ausgebildet sind. Eine Steckbaugruppe wird in einem Baugruppenträger lediglich durch wenigstens eine Schraube gehalten, die die Frontplatte oder -blende durchsetzt und mit dem Baugruppenträger verschraubt ist.

Erfindungsgemäß ist die Halterung als Frontplatte für eine Frontblendenöffnung des Baugruppenträgers ausgebildet, mit einer Ausnehmung für eine Schraube, mittels der die Frontplatte an dem Baugruppenträger anschraubbar ist. Desweiteren ist an die Frontplatte ein Aufnahmefach für wenigstens einen elektronischen Schaltkreis und den Schraubenkopf einer in die Ausnehmung eingesetzten Schraube angeformt, welches mit der Frontplatte unlösbar verbunden und mit einem aushärtenden Kunststoff ausgießbar ist.

Der zu schützende Schaltkreis wird entweder direkt oder auf eine Leiterplatte montiert in das Aufnahmefach eingebaut. Zur Montage wird die Frontplatte an den Baugruppenträger angeschraubt. Danach kann das Aufnahmefach mit einem flüssigen Kunststoff, beispielsweise einem später aushärtenden Zweikomponenten-Gießharz ausgegossen werden. Dieses umhüllt den Schaltkreis und den Schraubenkopf, so daß beide nicht mehr zugänglich sind, ohne die Frontplatte, die Vergußmaße und/oder den Schaltkreis zu zerstören.

Die Erfindung ist gleichermaßen bei Baugruppenträgern verschiedener Standards, so z.B. bei 19"-Aufbausystemen nach IEC-Publikation 297 oder bei Aufbauten im PC-AT-Format anwendbar. Den jeweiligen Standard verletzende Änderungen sind dabei nicht erforderlich.

Der zu schützende Schaltkreis mag über ein Kabel, welches aus dem Aufnahmefach herausführt, mit einer Steuer- oder Interfaceschaltung verbunden sein. Um die Steuer- und Interfaceschaltung mit dem Schaltkreis zu einer Einheit zusammenfassen zu können, wird in einer Weiterbildung der Erfindung vorgeschlagen, die Halterung auf der in das Innere des Baugruppenträgers weisenden Seite mit wenigstens einer Befestigungslasche für eine die Steuer- und Interfaceschaltung tragende Leiterplatte zu versehen. Bei Defekten an der Steuer- und Interfaceschaltung kann die Leiterplatte ausgetauscht werden, ohne die Halterung von dem Baugruppenträger lösen zu müssen.

Die Frontplatte kann mit den Wänden des Aufnahmefachs einstückig als Stanz-Biegeteil aus Blech oder auch als Gußteil oder Spritzgußteil aus Kunststoff oder Metall gefertigt sein.

Weitere Merkmale und Vorteile der Erfindung sind den Unteransprüchen und der folgenden Beschreibung und Zeichnung eines Ausführungsbeispiels zu entnehmen. Es zeigt
- Figur 1: eine Frontblende im PC-AT-Format mit einem Aufnahmefach und einem darin angeordneten zu schützenden elektronischen Schaltkreis in perspektivischer Draufsicht.
- Figur 2: ein Anschlußfeld eines Baugruppenträgers im PC-AT-Format in perspektivischer Vorderansicht.

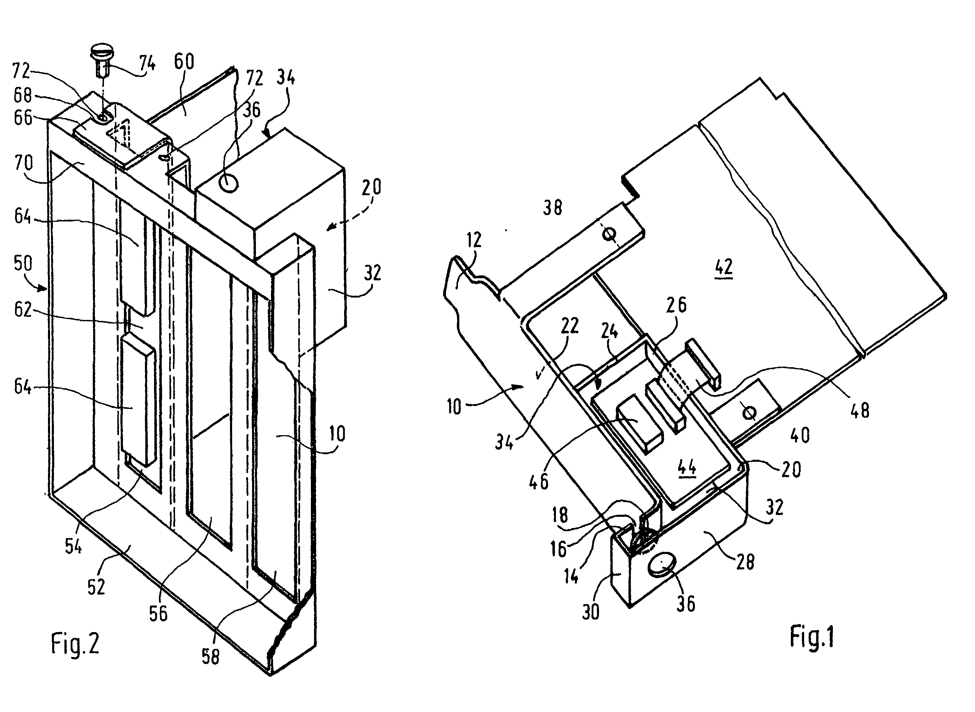

In Figur 1 ist eine als Frontblende im PC-AT-Format ausgeführte Frontplatte allgemein mit 10 bezeichnet. An ihrem beim Einstecken in einen Baugruppenträger 50 (Figur 2) voraneilenden Ende trägt die Frontblende 10 eine Kontaktzunge 12, über die die Frontblende mit dem Massepotential des Baugruppenträgers verbunden wird. Das andere Ende der Frontblende 10 ist nach vorne um 90° abgebogen und bildet einen Befestigungslappen 14. Dieser trägt eine zu einer Seite offene schlitzförmige Ausnehmung 16 für eine Schraube 18, mittels der die Frontblende 10 an dem Baugruppenträger 50 festgeschraubt werden kann, wie weiter unten noch beschrieben wird.

Ein winkelförmiges Aufnahmefach 20 erstreckt sich über den Befestigungslappen 14 und einen Teil der Rückseite 22 der Frontblende 10. Das Aufnahmefach 20 wird von der Frontblende 10, dem Befestigungslappen 14, einer unteren Wand 24, einer hinteren, parallel zu der Rückseite 22 verlaufenden Wand 26, einer oberen, parallel zu dem Befestigungslappen 14 verlaufende Wand 28, einer vorderen, parallel zu der Frontblende 10 verlaufenden Wand 30 und einem Boden 32 begrenzt. Dem Boden 32 gegenüber liegt eine Öffnung 34. In die obere Wand 28 ist gegenüber der Ausnehmung 16 eine Bohrung 36 eingebracht, durch die hindurch die Schraube 18 mit einem Schraubendreher gedreht werden kann.

An das untere Ende der Frontblende 10 und die hintere Wand 26 des Aufnahmefachs 20 sind Befestigungslaschen 38, 40 für eine erste Leiterplatte 42 angeformt, welche von der Rückseite 22 der Frontblende 10 senkrecht absteht und dem PC-AT-Standard genügt. In das Aufnahmefach 20 ist eine zweite Leiterplatte 44 eingebaut, die einen zu sichernden Schaltkreis 46 trägt. Die Leiterplatten 42 und 44 sind über ein Flachbandkabel 48 mit einander elektrisch verbunden.

Die Frontblende 10, die Wände 24, 26, 28, 30 und der Boden 32 des Aufnahmefachs 20 und die Befestigungslaschen 38, 40 können einstückig als Stanz-Biegeteil aus Blech, oder auch als Guß- oder Spritzgußteil aus Kunststoff oder Metall hergestellt sein. Ferner kann die Öffnung 34 nach dem Einsetzen der zweiten Leiterplatte 44 durch einen nicht dargestellten Deckel verschlossen sein. Dieser ist dann lediglich mit einem Durchlaß für ein weiter unten erwähntes Flachbandkabel 48 zu versehen.

Der Schaltkreis 46 ist im Ausführungsbeispiel nach Figur 1 als ein einziger Chip dargestellt. Er kann aber auch aus mehreren Chips und/oder diskreten Bauelementen aufgebaut sein. Der Schaltkreis 46 kann z.B. ein Fiskalspeicher sein, wie er in verschiedenen Ländern für Registrierkassen gesetzlich vorgeschrieben ist. In einem solchen Fiskalspeicher muß unlöschbar und unveränderbar eine Steuerbezeichnung, eine Matrikelnummer, die laufenden Nummern der ausgegebenen Kassenbons und die darauf abgedruckten Umsatzdaten gespeichert werden. Ein Fiskalspeicher muß unlösbar am Gehäuse des Gerätes befestigt sein. In dem Aufnahmefach 20 kann auch zumindest der zu schützende Schlüsselwortspeicher eines sogenannter "Dongle" untergebracht sein. Hierbei handelt es sich um einen kodierten Schaltkreis, der vorhanden sein muß, damit ein mit diesem geschütztes Computerprogramm ablaufen kann. Der nicht zu schützende Schaltungsteil der jeweiligen Schaltungsanordnung -im allgemeinen eine Steuer- und Interfaceschaltung für den zu schützenden Schaltungsteilkann auf der an die Frontblende 10 angelaschten ersten Leiterplatte 42 angeordnet sein. Auf eine mechanische Verbindung zwischen dieser und der Frontblende 10 kann aber auch verzichtet werden.

In Figur 2 ist nur das Anschlußfeld 52 eines mit drei Steckplätzen ausgestatteten Baugruppenträgers 50 dargestellt. Das Anschlußfeld 52 hat drei Frontblendenöffnungen 54, 56, 58, die jeweils einem Steckplatz zugeordnet sind. Die drei Steckplätze gleichen einander. Der linke Steckplatz ist mit einer Steckbaugruppe 60 mit einer Standard-Frontblende 62 bestückt. Auf dieser sind Kabelanschlußstecker 64 angebracht. Die Standard-Frontblende 62 trägt an ihrem oberen Ende einen mit einer Ausnehmung 68 versehenen Befestigungslappen 66, der auf einer oberen Traverse 70 des Anschlußfeldes 52 aufliegt. Die Ausnehmung 68 läßt eine Gewindebohrung 72 in der Traverse 70 frei, in die eine Schraube 74 eingedreht werden kann. Diese dient der lösbaren Befestigung der Standard-Frontblende 62 an dem Anschlußfeld 52 und damit der Steckbaugruppe 60 in dem Baugruppenträger 50.

Der mittlere Steckplatz und damit die Frontblendenöffnung 56 ist frei. Letztere kann mit einer nicht dargestellten Blind-Frontblende verschlossen werden, die wie die Standard-Frontblende 62 aufgebaut und an dem Anschlußfeld 52 zu befestigen ist.

Die rechte Frontblendenöffnung 58 ist durch die Frontblende 10 verschlossen. Die Bohrung 36 weist nach oben. Ist die Öffnung 34 durch einen oben erwähnten Deckel verschlossen, so kann das Aufnahmefach 20 nach dem Festschrauben der Schraube 18 (Figur 1) in der Gewindebohrung 72 des Steckplatzes 58 durch die Bohrung 36 hindurch mit flüssigem Kunststoff gefüllt werden. Die Schraube 18 und die zweite Leiterplatte 44 mitsamt dem darauf befindlichen Schaltkreis 46 werden dabei von dem Kunststoff umschlossen. Nach dem Aushärten des Kunststoffs kann die Schraube 18 nicht mehr gelöst werden.

Ist kein Deckel für die Öffnung 34 vorgesehen, so ist der Baugruppenträger 50 auf die in Figur 2 rechte Seite zu legen, so daß die Öffnung 34 nach oben weist. Durch diese hindurch kann das Aufnahmefach 20 dann in gleicher Weise mit Kunststoff ausgegossen werden. Lediglich das Flachbandkabel 48 ragt aus diesem heraus.

## Patentansprüche

1. Halterung für wenigstens einen elektronischen Schaltkreis, die diesen gegen Manipulation und unbefugte Entfernung von einem Baugruppenträger sichert welche als Frontplatte (10) für eine Frontblendenöffnung (58) des Baugruppenträgers (50) ausgebildet ist und eine Ausnehmung (16) für eine Schraube (18) aufweist, mittels der die Frontplatte (10) an dem Baugruppenträger (50) anschraubbar ist, **dadurch gekennzeichnet**, daß an die Frontplatte (10) ein Aufnahmefach (20) für wenigstens einen elektronischen Schaltkreis (46) und den Schraubenkopf einer in die Ausnehmung eingesetzten Schraube (18) angeformt ist, welches mit der Frontplatte (10) unlösbar verbunden und mit einem aushärtenden Kunststoff ausgießbar ist.

2. Anordnung nach Anspruch 1, bei der die Frontplatte (10) eine Kartenblende im PC-AT-Format ist.

3. Anordnung nach Anspruch 1 oder 2 mit wenigstens einer Befestigungslasche (38, 40) für eine Leiterplatte (42).

4. Anordnung nach einem der Ansprüche 1 bis 3, bei der die Frontplatte (10) mit den Wänden (24, 26, 28, 30) des Aufnahmefachs (20) einstückig als Stanz-Biegeteil aus Blech gefertigt ist.

5. Anordnung nach einem der Ansprüche 1 bis 3, bei der die Frontplatte mit den Wänden des Aufnahmefachs einstückig als Gußteil aus Kunststoff oder Metall gefertigt ist.

6. Anordnung nach einem der Ansprüche 1 bis 5, bei der der elektronische Schaltkreis (46) einen elektronischen Journalspeicher und/oder einen Fiskalspeicher umfaßt.

7. Anordnung nach einem der Ansprüche 1 bis 6, bei der der elektronische Schaltkreis (46) einen Dongle umfaßt.

## Claims

1. Holding device for at least one electronic circuit which secures the latter against manipulation and unauthorized removal from a card rack, which device is designed as a front plate (10) for a front-panel opening (58) of the card rack (50) and has a clearance (16) for a screw (18), by means of which the front plate (10) can be screwed on the card rack (50), **characterized in that** on the front plate (10) there is formed a receiving compartment (20) for at least one electronic circuit (46) and the screw head of a screw (18) inserted into the clearance, which compartment is undetachably connected to the front plate (10) and can be filled with a curable plastic.

2. Arrangement according to Claim 1, in which the front plate (10) is a card panel in PC-AT format.

3. Arrangement according to Claim 1 or 2 with at least one fixing strap (38, 40) for a printed-circuit board (42).

4. Arrangement according to one of Claims 1 to 3, in which the front plate (10) is produced in one piece with the walls (24, 26, 28, 30) of the receiving compartment (20) as a punched-bent part from sheet metal.

5. Arrangement according to one of Claims 1 to 3, in which the front plate is produced in one piece with the walls of the receiving compartment as a cast part from plastic or metal.

6. Arrangement according to one of Claims 1 to 5, in which the electronic circuit (46) comprises an electronic journal memory and/or a fiscal memory.

7. Arrangement according to one of Claims 1 to 6, in -which the electronic circuit (46) comprises a dongle.

## Revendications

1. Fixation pour au moins un circuit électronique qui le protège de manipulations et l'empêche d'être enlevé d'un porte-modules de manière non autorisée, qui est réalisée en plaque (10) frontale pour une ouverture (58) de panneau frontal du porte-modules (50) et qui comporte un évidement (16) pour une vis (18) au moyen de laquelle la plaque (10) frontale peut être vissée au porte-modules (50), **caractérisée en ce qu**'il est ménagé sur la plaque (10) frontale un casier (20) de réception pour au moins un circuit (46) électronique et pour la tête d'une vis introduite dans l'évidement, le casier de réception étant relié de manière inamovible à la plaque (10) frontale et scellé par une matière plastique thermodurcissable.

2. Dispositif suivant la revendication 1, dans lequel la plaque (10) frontale est un panneau de carte en le format PC-AT.

3. Dispositif suivant la revendication 1 ou 2, comportant au moins une patte (38, 40) de fixation pour une plaquette (42) à circuit imprimé.

4. Dispositif suivant l'une des revendications 1 à 3, dans lequel la plaque (10) frontale est fabriquée d'un seul tenant avec les parois (24, 26, 28, 30) du casier (20) de réception sous forme de pièce en tôle obtenue par pliage et découpage.

5. Dispositif suivant l'une des revendications 1 à 3, dans lequel la plaque frontale est fabriquée d'un seul tenant avec les parois du casier de réception sous forme de pièce de coulée en matière plastique ou en métal.

6. Dispositif suivant l'une des revendications 1 à 5, dans lequel le circuit (46) électronique comprend une mémoire de journal électronique et/ou une mémoire fiscale.

7. Dispositif suivant l'une des revendications 1 à 6, dans lequel le circuit (46) électronique comporte un dongle.
